# EUROPÄISCHE PATENTSCHRIFT

(11) **EP 0 526 867 B1**
(45) Veröffentlichungstag und Bekanntmachung des Hinweises auf die Patenterteilung: **05.11.1997**
(21) Anmeldenummer: 92113215.5
(22) Anmeldetag: 03.08.1992
(51) Int. Cl.: G03F 7/00, G03F 7/24, B41C 1/18, B41N 6/00, B41N 3/00, C23F 1/04

(54) **Verfahren zur Herstellung eines walzenförmigen Prägewerkzeugs**
Process for making a cylindrical embossing tool
Procédé pour la fabrication d'un outil d'emboutissage cylindrique

(30) Priorität: 05.08.1991 DE 4125931
(43) Veröffentlichungstag der Anmeldung: 10.02.1993
(73) Patentinhaber: GERHARDT INTERNATIONAL A/S, DK-2770 Kastrup (DK)
(72) Erfinder: Gerhardt, Jorgen, DK-2791 Dragor (DK)
(74) Vertreter: Liska, Horst, Dr.-Ing.

(56) Entgegenhaltungen:
- DE-A- 2 009 491
- DE-B- 1 182 194
- US-A- 2 383 080
- US-A- 4 116 594
- PATENT ABSTRACTS OF JAPAN vol. 004, no. 019 (C-073)16. Februar 1980 & JP-A-54 155 946 ( TOSHIBA CORP ) 8. Dezember 1979
- PATENT ABSTRACTS OF JAPAN vol. 014, no. 305 (M-0992)29. Juni 1990 & JP-A-20 99 207 ( NIPPON STEEL CORP ) 11. April 1990

## Beschreibung

Die Erfindung betrifft ein Verfahren zur Herstellung eines walzenförmigen Prägewerkzeugs zum Prägen eines positiven und/oder negativen Reliefs auf wenigstens eine Seite eines Flachmaterials.

Aufgabe der Erfindung ist es, ein Verfahren dieser Art anzugeben, mittels dem ein dem zu prägenden Relief mit hoher Genauigkeit angepaßtes Prägewerkzeug verzerrungsfrei hergestellt werden kann.

Zur Lösung dieser Aufgabe ist das Verfahren dadurch gekennzeichnet, daß in einem Belichtungsschritt ein im ebenen Zustand befindliches Blech - vorzugsweise einer Dicke von 0,40 mm bis 1,00 mm - auf einer Seite mit einer Fotoresistschicht versehen und durch einen Film - oder eine äquivalente Schablone - , der bzw. die mit einem dem Relief entsprechenden Muster versehen ist, belichtet wird, daß dann in einem Entwicklungsschritt die unbelichteten Bereiche der Fotoresistschicht entfernt werden, so daß die belichteten gehärteten Bereiche der Fotoresistschicht stehenbleiben, daß dann das Blech um eine Walze hülsenförmig derart gebogen wird, daß seine belichteten gehärteten Bereiche nach außen weisen, daß dann das hülsenförmig gebogene - vorzugsweise noch auf der Walze befindliche - Blech um seine Achse gedreht und die zwischen den belichteten - gehärteten - Bereichen der Fotoresistschicht liegenden Bereiche des Blechs bis zu einer vorgegebenen Tiefe - von vorzugsweise 0,20 mm bis 0,60 mm - mit einer Ätzflüssigkeit herausgeätzt werden, daß dann von dem um die Walze oder um eine andere Walze gleichen Durchmessers gelegten, hülsenförmig gebogenen Blech die belichteten gehärteten Bereiche der Fotoresistschicht entfernt werden, daß dann die zueinander weisenden Kanten des hülsenförmigen, mit seiner geätzten Seite nach außen weisenden Blechs zur Bildung einer Blechhülse wenigstens stellenweise miteinander verbunden werden und daß dann die Blechhülse auf der Walze oder einer anderen Walze gleichen Durchmessers befestigt wird.

Aus der US-A-4116594 ist ein Verfahren zur Herstellung eines walzenförmigen Prägewerkzeugs zum Prägen eines positiven und/oder negativen Reliefs auf wenigstens eine Seite eines Flachmaterials bekannt, bei dem zunächst in einem Belichtungsschritt ein im ebenen Zustand befindliches Blech auf einer Seite mit einer Fotoresistschicht versehen und durch einen Film, der mit einem dem Relief entsprechenden Muster versehen ist, belichtet wird, dann in einem Entwicklungsschritt die unbelichteten Bereiche der Fotoresistschicht entfernt werden, so daß die belichteten gehärteten Bereiche der Fotoresistschicht stehenbleiben, dann die zwischen den belichteten gehärteten Bereichen der Fotoresistschicht liegenden Bereiche des Blechs bis zu einer vorgegebenen Tiefe mit einer Ätzflüssigkeit herausgeätzt werden, und anschließend das Blech mit seiner geätzten Seite nach außen weisend um eine Walze gelegt wird.

Für die Güte dieses Verfahrens ist entscheidend, daß das Blech im ebenen Zustand belichtet und im hülsenförmigen Zustand geätzt wird. Auch der Entwicklungsschritt wird vorzugsweise gemäß Anspruch 2 an dem im ebenen Zustand befindlichen Blech vorgenommen.

Grundsätzlich ist es nicht notwendig, daß das Blech beim Belichten und gegebenenfalls Entwickeln schon dem Umfang der Walze angepaßt ist. In diesem Fall wird das Blech jedoch, bevor es um die Walze gebogen wird, dem Umfang der Walze angepaßt.

Das Blech braucht nicht auf derjenigen Walze geätzt zu werden, auf die es schließlich als Hülse aufgebracht wird. In jedem Fall empfiehlt es sich jedoch, das Blech beim Ätzen durch ätzfeste entfernbare Klebestreifen an der jeweiligen Walze zu sichern.

Um aus dem Blech eine dauerhafte Hülse zu machen, werden bevorzugt die zueinander weisenden Kanten des Blechs zur Bildung der Hülse durch Punktschweißen miteinander verbunden. Jedenfalls erhält die Blechhülse bevorzugt einen Innendurchmesser, der etwas kleiner als der Durchmesser der Walze ist, damit sie auf die Walze durch Erhitzen, Aufstecken auf die Walze und anschließendes Abkühlen thermisch geschrumpft werden kann. Die Abmessungstoleranzen können dabei so gering sein, daß vor dem Aufschrumpfen die Walze in die Blechhülse zu pressen ist.

Die eine Möglichkeit zum Aufbringen der Blechhülse auf die Walze besteht somit darin, daß die Blechhülse auf die Walze durch thermische Verringerung ihres Durchmessers geschrumpft wird.

Eine andere Möglichkeit ist aber auch, daß die Blechhülse auf die Walze durch thermische Vergrößerung des Durchmessers der Walze - vorzugsweise unter Verwendung eines in einem Innenraum der Walze befindlichen Heizelements - geschrumpft wird. Eine solche Blechhülse braucht dann nur, wenn das Heizelement wirksam ist, also etwa nur während der Benutzung des Prägewerkzeugs, fest auf der Walze zu sitzen, sonst aber nicht, so daß sie leicht ausgetauscht werden kann.

Als Material für die Walze hat sich besonders Stahl und Messing bewährt.

Die Erfindung wird im folgenden an einem Ausführungsbeispiel unter Hinweis auf die beigefügten Zeichnungen beschrieben.

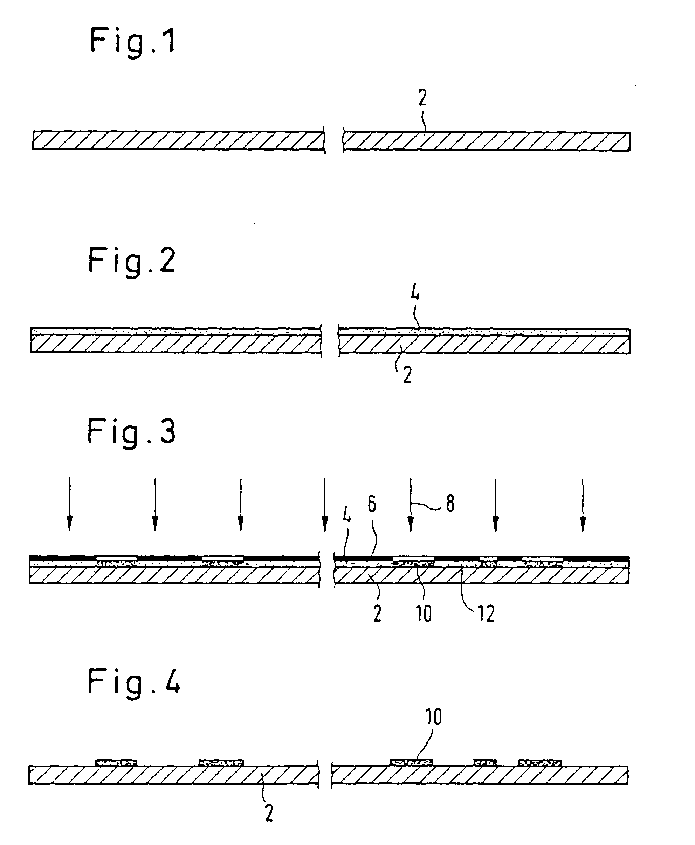

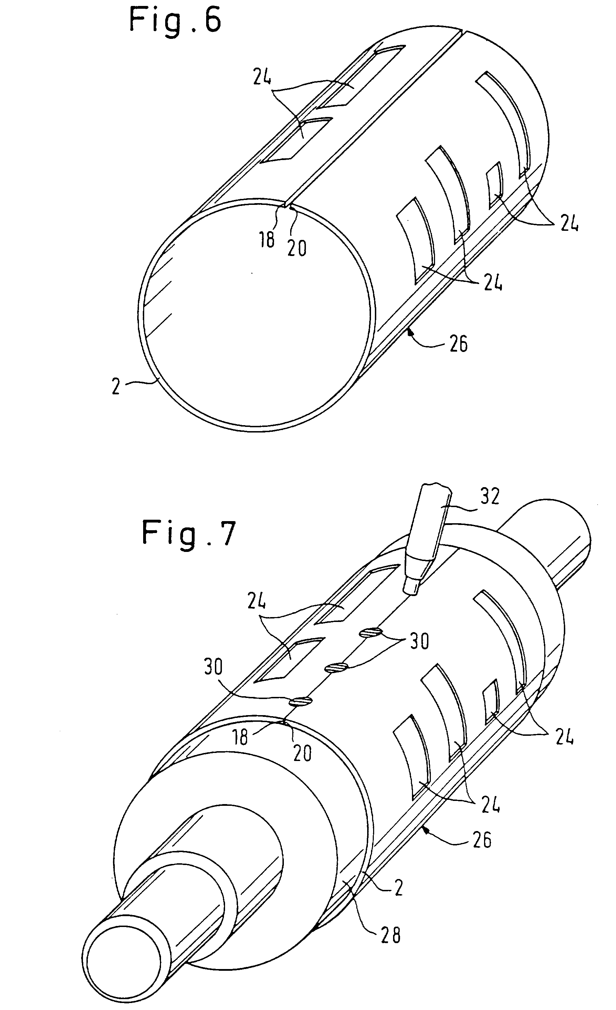

Die Fig. 1 bis 7 zeigen aufeinanderfolgende Verfahrensschritte des Beispiels.

Gemäß Fig. 1 wird von einem ebenen Blech 2 ausgegangen. Dieses Blech 2 wird gemäß Fig. 2 mit einer Schicht 4 eines Fotoresists versehen. Gemäß Fig. 3 wird auf die Fotoresistschicht 4 ein Film 6 gelegt, durch den die Fotoresistschicht 4 belichtet wird (Pfeile 8). Die Bereiche 10 der Fotoresistschicht 4, auf die das Licht fällt, werden durch die Belichtung gehärtet. Anschließend wird der Film 6 entfernt und die unbelichteten Bereiche 12 der Fotoresistschicht 4 werden weggewaschen. Es verbleibt somit gemäß Fig. 4 das Blech 2 mit den belichteten gehärteten Bereichen 10 der ehemaligen Fotoresistschicht 4.

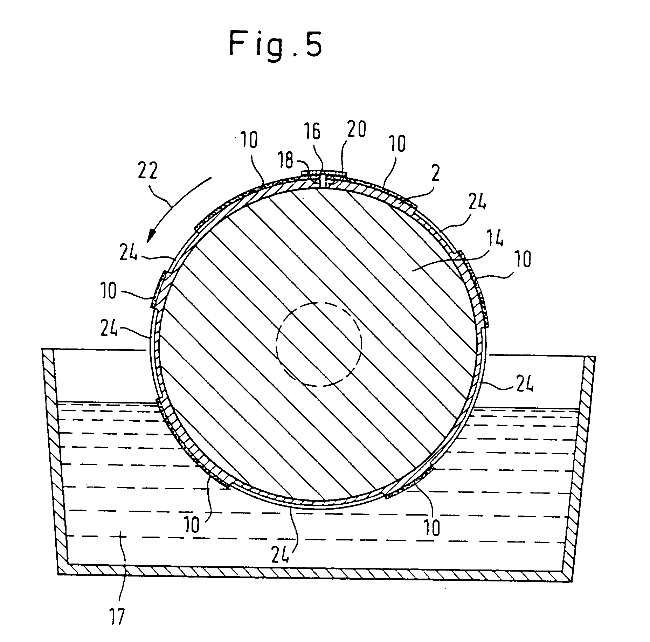

Dieses Blech 2 wird nun gemäß Fig. 5 um eine Walze 14 gelegt und dort mit Haftstreifen 16, die die einander zugewandten Kanten 18, 20 des Blechs 2 überdecken, gesichert.

Die Walze 14 mit dem auf ihr befindlichen Blech 2 wird nun in ein Ätzbad 17 getaucht und in Richtung des Pfeils 22 um ihre Achse gedreht. Dabei werden diejenigen Bereiche 24 des Blechs 2, die zwischen den gehärteten ätzfesten Bereichen 10 der ehemaligen Fotoresistschicht 4 liegen, herausgeätzt.

Anschließend werden die Haftstreifen 16 entfernt und auch die ätzfesten Bereiche 10. Dann kann die axial geschlitzte Hülse 26, die aus dem Blech 2 entstanden ist, von der Walze 14 abgenommen werden und auf eine Werkzeugwalze 28 gesteckt werden, wo ihre einander zugewandten Kanten 18, 20 durch Schweißpunkte 30 mittels eines Schweißwerkzeugs 32 miteinander verbunden werden.

## Patentansprüche

1. Verfahren zur Herstellung eines walzenförmigen Prägewerkzeugs zum Prägen eines positiven und/oder negativen Reliefs auf wenigstens eine Seite eines Flachmaterials,
**dadurch gekennzeichnet,**
daß in einem Belichtungsschritt ein im ebenen Zustand befindliches Blech (2) - vorzugsweise einer Dicke von 0,40 mm bis 1,00 mm - auf einer Seite mit einer Fotoresistschicht (4) versehen und durch einen Film (6) - oder eine äquivalente Schablone - , der bzw. die mit einem dem Relief entsprechenden Muster versehen ist, belichtet wird, daß dann in einem Entwicklungsschritt die unbelichteten Bereiche (12) der Fotoresistschicht (4) entfernt werden, so daß die belichteten gehärteten Bereiche (10) der Fotoresistschicht (4) stehenbleiben, daß dann das Blech (2) um eine Walze (14) hülsenförmig derart gebogen wird, daß seine belichteten - gehärteten - Bereiche (10) nach außen weisen, daß dann das hülsenförmig gebogene - vorzugsweise noch auf der Walze (14) befindliche - Blech (2) um seine Achse gedreht und die zwischen den belichteten gehärteten Bereichen (10) der Fotoresistschicht (4) liegenden Bereiche (24) des Blechs (2) bis zu einer vorgegebenen Tiefe - von vorzugsweise 0,20 mm bis 0,60 mm - mit einer Ätzflüssigkeit herausgeätzt werden, daß dann von dem um die Walze (14) oder um eine andere Walze gleichen Durchmessers gelegten, hülsenförmig gebogenen Blech (2) die belichteten gehärteten Bereiche (10) der Fotoresistschicht (4) entfernt werden, daß dann die zueinander weisenden Kanten des hülsenförmigen, mit seiner geätzten Seite nach außen weisenden Blechs (2) zur Bildung einer Blechhülse (26) wenigstens stellenweise miteinander verbunden werden und daß dann die Blechhülse (26) auf der Walze (14) oder einer anderen Walze (28) gleichen Durchmessers befestigt wird.

2. Verfahren nach Anspruch 1, dadurch gekennzeichnet, daß auch der Entwicklungsschritt an dem im ebenen Zustand befindlichen Blech (2) vorgenommen wird.

3. Verfahren nach Anspruch 1 oder 2, dadurch gekennzeichnet, daß das Blech (2), bevor es um die Walze (14) gebogen wird, dem Umfang der Walze (14) angepaßt wird.

4. Verfahren nach einem der vorstehenden Ansprüche, dadurch gekennzeichnet, daß das hülsenförmig gebogene Blech (2) durch ätzfeste, entfernbare Klebestreifen (16) an der Walze (14) gesichert wird.

5. Verfahren nach einem der vorstehenden Ansprüche, dadurch gekennzeichnet, daß die zueinander weisenden Kanten (18, 20) des hülsenförmig gebogenen Blechs (2) zur Bildung der Blechhülse (26) durch Punktschweißen miteinander verbunden werden.

6. Verfahren nach Anspruch 5, dadurch gekennzeichnet, daß die Blechhülse (26) auf die Walze thermisch geschrumpft wird.

7. Verfahren nach Anspruch 5 oder 6, dadurch gekennzeichnet, daß die Walze in die Blechhülse (26) gepreßt wird.

8. Verfahren nach Anspruch 6 oder 7, dadurch gekennzeichnet, daß die Blechhülse (26) durch thermische Vergrößerung ihres Durchmessers, Aufstecken auf die Walze und anschließende Verringerung ihres Durchmessers auf die Walze geschrumpft wird.

9. Verfahren nach Anspruch 6 oder 7, dadurch gekennzeichnet, daß die Blechhülse (26) auf der Walze durch thermische Vergrößerung des Durchmessers der Walze - vorzugsweise unter Verwendung eines in einem Innenraum der Walze befindlichen Heizelements - befestigt wird.

10. Verfahren nach einem der vorstehenden Ansprüche, dadurch gekennzeichnet, daß die Walze aus Stahl oder Messing besteht.

## Claims

1. Process for making a cylindrical embossing tool for embossing a positive and/or negative relief on at least one side of a flat material, characterised in that in an exposure step, sheet metal (2) located in a flat state - preferably having a thickness of 0.40 mm to 1.00 mm - is provided on one side with a photo-resist layer (4) and is exposed through a film (6) - or an equivalent template - , which is provided with a pattern corresponding to the relief, that then in a developing step the unexposed regions (12) of the photo-resist layer (4) are removed, so that the exposed hardened regions (10) of the photo-resist layer (4) remain, that then the sheet metal (2) is bent in the form of a sleeve around a cylinder (14) so that its exposed - hardened - regions (10) are directed outwards, that then the sheet metal (2) bent in the form of a sleeve - preferably still located on the cylinder (14) - is rotated about its axis and the regions (24) of the sheet metal (2) lying between the exposed, hardened regions (10) of the photo-resist layer (4) are etched out with an etching liquid up to a predetermined depth - of preferably 0.20 mm to 0.60 mm, that then the exposed, hardened regions (10) of the photo-resist layer (4) are removed from the sheet metal (2) bent in the form of a sleeve and laid around the cylinder (14) or around another cylinder of the same diameter, that then the edges pointing towards each other of the sleeve-shaped sheet metal (2) with its etched side pointing outwards are connected to each other at least at points to form a sheet metal sleeve (26) and that then the sheet metal sleeve (26) is fastened on the cylinder (14) or another cylinder (28) of the same diameter.

2. Process according to Claim 1, characterised in that even the developing step is carried out on the sheet metal (2) located in the flat state.

3. Process according to Claim 1 or 2, characterised in that before it is bent around the cylinder (14), the sheet metal (2) is adapted to the periphery of the cylinder (14).

4. Process according to one of the preceding Claims, characterised in that the sheet metal (2) bent in the shape of a sleeve is fastened to the cylinder (14) by removable adhesive strips (16) which are resistant to etching.

5. Process according to one of the preceding Claims, characterised in that the edges (18, 20) pointing towards each other of the sheet metal (2) bent in the form of a sleeve are connected to each other by spot welding to form the sheet metal sleeve (26).

6. Process according to Claim 5, characterised in that the sheet metal sleeve (26) is shrunk thermally onto the cylinder.

7. Process according to Claim 5 or 6, characterised in that the cylinder is pressed into the sheet metal sleeve (26).

8. Process according to Claim 6 or 7, characterised in that the sheet metal sleeve (26) is shrunk onto the cylinder by thermal enlargement of its diameter, mounting on the cylinder and subsequent reduction of its diameter.

9. Process according to Claim 6 or 7, characterised in that the sheet metal sleeve (26) is attached to the cylinder by thermal enlargement of the diameter of the cylinder - preferably using a heating element located in an inside space of the cylinder.

10. Process according to one of the preceding Claims, characterised in that the cylinder consists of steel or brass.

## Revendications

1. Procédé de fabrication d'un outil de gravure en forme de cylindre pour la gravure d'un relief positif et/ou négatif sur au moins une face d'un produit plat, caractérisé en ce qu'au cours d'une étape d'exposition, une tôle (2) - de préférence d'une épaisseur de 0,40 mm à 1,00 mm -, se trouvant à l'état plan, est pourvue sur une face d'une couche photorésistante (4) et est exposée à la lumière à travers un film (6) - ou un gabarit équivalent -, qui est pourvu d'un motif correspondant au relief, en ce qu'ensuite, au cours d'une étape de développement, les zones (12) non exposées de la couche photorésistante (4) sont éliminées, de manière que les zones (10) exposées, durcies, de la couche photorésistante (4) subsistent, en ce qu'ensuite la tôle (2) est cintrée en forme de cylindre autour d'un rouleau (14), de telle sorte que ces zones (10) exposées - durcies - sont dirigées vers l'extérieur, en ce qu'ensuite la tôle (2) cintrée en forme de cylindre - se trouvant de préférence encore sur le rouleau (14) - est tournée autour de son axe et les zones (24) de la tôle (2), se trouvant entre les zones (10) exposées, durcies, de la couche photorésistante (4), sont gravées jusqu'à une profondeur donnée - de préférence de 0,20 mm à 0,60 mm - au moyen d'un agent liquide de gravure, en ce qu'ensuite les zones (10) exposées, durcies, de la couche photorésistante (4) sont enlevées de la tôle (2), cintrée en forme de cylindre, placée autour du rouleau (14) ou autour d'un autre rouleau de même diamètre, en ce qu'ensuite les bords dirigés l'un vers l'autre de la tôle (2) en forme de cylindre, avec sa face gravée dirigée vers l'extérieur, sont assemblés entre eux, au moins par endroits pour former un cylindre en tôle (26) et en ce qu'ensuite le cylindre en tôle (26) est fixé sur le rouleau (14) ou sur un autre rouleau (28) de même diamètre.

2. Procédé selon la revendication 1, caractérisé en ce que le développement est effectué aussi sur la tôle (2) se trouvant à l'état plan.

3. Procédé selon la revendication 1 ou 2, caractérisé en ce que la tôle (2) est adaptée à la circonférence du rouleau (14), avant d'être cintrée autour du rouleau (14).

4. Procédé selon l'une des revendications précédentes, caractérisé en ce que la tôle (2), cintrée en forme de cylindre, est fixée sur le rouleau (14) par des bandes adhésives (16) amovibles, résistant à l'effet corrosif.

5. Procédé selon l'une des revendications précédentes, caractérisé en ce que les bords (18, 20) tournés l'un vers l'autre de la tôle (2) cintrée en forme de cylindre sont reliés entre eux par soudage par points, pour former le cylindre en tôle (26).

6. Procédé selon la revendication 5, caractérisé en ce que le cylindre en tôle (26) est rétracté thermiquement sur le rouleau.

7. Procédé selon la revendication 5 ou 6, caractérisé en ce que le rouleau est pressé dans le cylindre en tôle (26).

8. Procédé selon la revendication 6 ou 7, caractérisé en ce que le cylindre en tôle (26) est rétracté sur le rouleau par augmentation thermique de son diamètre, emboîtage sur le rouleau et réduction consécutive de son diamètre.

9. Procédé selon la revendication 6 ou 7, caractérisé en ce que le cylindre en tôle (26) est fixé sur le rouleau par augmentation thermique du diamètre du rouleau - de préférence par utilisation d'un élément chauffant se trouvant dans une chambre intérieure du rouleau -.

10. Procédé selon l'une des revendications précédentes, caractérisé en ce que le rouleau est constitué en acier ou en laiton.
